(19) Europäisches Patentamt

European Patent Office

Office européen des brevets

(11) Numéro de publication: **0 275 594 B1**

(12) **FASCICULE DE BREVET EUROPEEN**

(45) Date de publication de fascicule du brevet:
**10.07.91**

(21) Numéro de dépôt: **87202545.7**

(22) Date de dépôt: **16.12.87**

(51) Int. Cl.⁵: **G11C 7/06, G11C 11/419**

(54) **Mémoire monolithiquement intégrée incluant un circuit amplificateur différentiel de lecture.**

(30) Priorité: **23.12.86 FR 8618047**

(43) Date de publication de la demande:
**27.07.88 Bulletin 88/30**

(45) Mention de la délivrance du brevet:
**10.07.91 Bulletin 91/28**

(84) Etats contractants désignés:
**CH DE FR GB IT LI NL**

(56) Documents cités:

**IEEE TRANSACTIONS ON ELECTRON DEVI-CES, vol. ED-32, no. 9, septembre 1985, pages 1792-1796, IEEE, New York, US; H. SHINO-HARA et al.: "A fast 8K x 8 mixed CMOS static RAM"**

**IEEE JOURNAL OF SOLID STATE CIRCUITS, vol. SC-19, no. 5, octobre 1984, pages 564-571, IEEE, New York, US; S.E. SCHUSTER et al.: "A 20 ns 64K (4Kx16) NMOS RAM"**

**IEEE TRANSACTIONS ON NUCLEAR SCIEN-CE, vol. NS-30, no. 6, décembre 1983, pages 4183-4186, IEEE, New York, US; W.M. SHEDD et al.: "Transient radiation effects on silicon**

**MESFET integrated circuits"**

(73) Titulaire: **LABORATOIRES D'ELECTRONIQUE PHILIPS**
**3, Avenue Descartes**
**F-94450 Limeil-Brévannes(FR)FR**

Titulaire: **N.V. Philips' Gloeilampenfabrieken**
**Groenewoudseweg 1**
**NL-5621 BA Eindhoven(NL)CH DE GB IT LI NL**

(72) Inventeur: **Ducourant, Thierry Société Civile S.P.I.D.**
**209, rue de l'Université**
**F-75007 Paris(FR)**
Inventeur: **Gabillard, Bertrand Société Civile S.P.I.D.**
**209, rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

**Description**

L'invention concerne une mémoire réalisée au moyen de transistors à effet de champ à enrichissement, sur un substrat semiconducteur du groupe III-V, de préférence en arséniure de gallium (GaAs), comprenant une matrice de mémoire arrangée en rangées et colonnes, chaque cellule de mémoire d'une colonne étant connectée à une première et une seconde ligne de bit, lesquelles sont couplées à un amplificateur différentiel de lecture, ce circuit amplificateur différentiel de lecture comprenant deux transistors à effet de champ couplés par leur source, le point de couplage de ces transistors étant commandé par une source de courant et cette dernière étant commandée par la sortie d'un étage décodeur permettant la sélection de la colonne de mémoire, les grilles de chacun des transistors couplés recevant le signal d'une ligne de bit de la colonne de la mémoire et les drains de ces transistors couplés fournissant un signal porté sur le bus de lecture de la mémoire.

Un circuit amplificateur différentiel de lecture pour mémoire RAM statique est connu de la publication intitulée "Design of GaAs 1k bits static RAM par MASAYUKI INO, and alii dans IEEE Transactions on Electron Devices, Vol.ED-31, N° 9 September 1984". Ce document décrit une mémoire statique 1k bits réalisée à l'aide de transistors à effet de champ en arséniure de gallium (GaAs) en technologie dite "Direct coupled FET logic" (DCFL) qui présente une faible consommation, une grande vitesse de fonctionnement et une grande densité d'intégration.

Mais la capacité grille-drain qui apparaît en fonctionnement sur les transistors couplés de cet amplificateur différentiel ralentit le temps de montée des signaux de sortie recueillis sur le bus de lecture, et donc augmente le temps d'accès de la mémoire, et le temps de transition du signal de sortie.

Selon l'invention, ces inconvénients sont évités au moyen d'une mémoire telle que décrit dans le préambule, caractérisé en ce qu'il lui est adjoint un circuit translateur des niveaux des signaux transportés par les lignes de bit pour que ces niveaux soient au plus égaux aux niveaux des signaux portés par le bus de lecture, les entrées du circuit translateur de niveau étant connectées aux lignes de bit et les sorties du circuit translateur de niveau étant connectées aux grilles des transistors couplés par leur source en sorte que les capacités grille-drain des transistors couplés de l'amplificateur différentiel sont négligeables.

Dans une mise en oeuvre de l'invention, cette mémoire est caractérisée en ce que, le circuit translateur de niveaux est formé d'un premier couple de transistors à effet de champ montés en drain commun à l'alimentation continue positive $V_{DD}$, dont les grilles reçoivent les signaux des lignes de bit de la colonne de la mémoire, et dont les sources sont chacune raccordées au drain d'un des transistors d'un second couple de transistors à effet de champ dont les sources sont connectées à la masse à travers une résistance et dont les grilles sont reliées en croix d'une part au drain du transistor opposé de ce couple et d'autre part respectivement aux grilles des transistors de l'amplificateur différentiel de lecture, les lignes du bus de lecture étant reliées à l'alimentation continue $V_{DD}$ à travers des résistances appariées.

L'invention présente alors entre autres, les avantages suivants :
- les niveaux des signaux de commande des grilles des transistors couplés formant l'amplificateur différentiel de lecture ne sont plus les niveaux des signaux des lignes de bit de la colonne de la mémoire associée, mais les niveaux prévus pour être au plus égaux aux niveaux circulant sur le bus de lecture.

Dans ces conditions les capacités grille-drain des transistors couplés de l'amplificateur différentiel de lecture sont totalement négligeables, ce qui induit que :
- la capacité parasite totale associée au bus de lecture est très faible ;
- le temps de montée des signaux de sortie de l'amplificateur différentiel de lecture est plus faible que si les signaux des lignes de bit étaient portés directement sur les grilles de ces transistors couplés ;
- le temps de transition du signal de sortie de l'amplificateur différentiel de lecture est plus faible du fait que la constante de temps RC est très faible ;
- le temps d'accès à la mémoire est plus faible ;
- la dispersion du temps d'accès est également réduite ;
- la mémoire RAM statique est donc beaucoup plus performante sans augmenter beaucoup sa taille puisque le circuit décaleur de niveaux ne nécessite que quatre transistors et une résistance supplémentaire par colonne de mémoire.

L'invention sera mieux comprise à l'aide de la description suivante illustrée par les figures ci-après annexées dont :
- la figure 1 qui représente l'amplificateur différentiel de lecture associé à une colonne de mémoire, et muni d'un circuit décaleur de niveaux selon l'invention ;

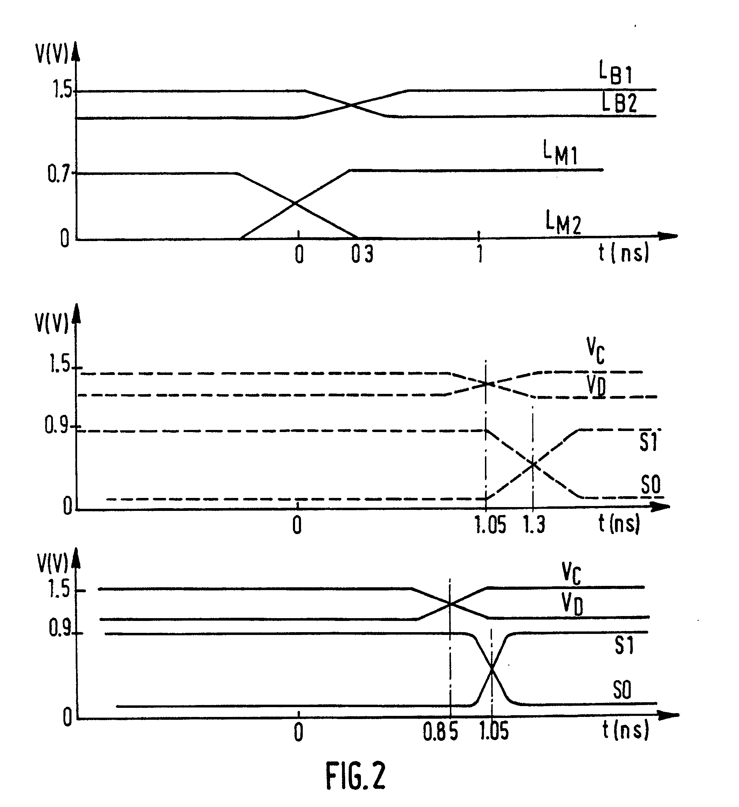

- la figure 2 qui représente le séquencement des signaux dans un circuit selon l'invention en trait plein comparés au séquencement des signaux dans un amplificateur de lecture non muni du décaleur de

2

niveau selon l'invention en trait discontinu.

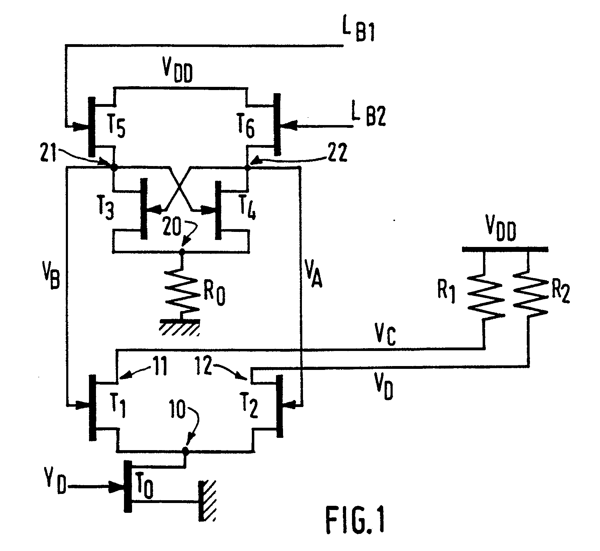

Tel que représenté sur la figure 1, l'amplificateur différentiel de lecture comprend donc d'abord un couple de transistors à effet de champ du type dit MESFET à enrichissement $T_1$ et $T_2$ dont la source commune 10 est reliée au drain d'un transistor $T_0$. Ce transistor $T_0$ dont la source est reliée à la masse, fonctionne en source de courant et est commandé par le signal $Y_D$ issu du décodeur qui sélectionne une colonne de la mémoire parmi N colonnes, l'amplificateur différentiel de lecture étant associé à une de ces colonnes, mais le circuit décodeur n'étant pas représenté. Les drains des transistors couplés $T_1$ et $T_2$ sont reliés respectivement aux deux lignes 11 et 12 du bus de lecture de la mémoire. Ces lignes 11 et 12 transportent les signaux $V_C$ et $V_D$. Les grilles 21 et 22 des transistors $T_1$ et $T_2$ reçoivent respectivement les signaux $V_B$ et $V_A$.

Chaque colonne de la mémoire est associée à un tel circuit amplificateur différentiel de lecture, comme il est connu du document cité comme état de la technique.

Selon ce document connu, les signaux $V_B$ et $V_A$ sont constitués par les signaux $L_{B1}$ et $L_{B2}$ respectivement transportés par les lignes de bit de la colonne de la mémoire.

Dans la réalisation connue d'une telle mémoire au moyen de transistors à effet de champ en arséniure de gallium, les lignes formant le bus de lecture sont portées à une tension d'alimentation $V_{DD}$ continue à travers des charges. Pour une alimentation continue :

$V_{DD} = 1,5$ volt

compatible avec ce circuit, les signaux portés par les lignes de bit ont pour amplitude :

$L_{B1} = 1,15$ volt

$L_{B2} = 1,45$ volt

et les signaux portés par le bus de lecture ont pour amplitude :

$V_C = 1,5$ volt et

$V_D = 1,15$ volt

Dans ces conditions, la différence d'amplitude entre par exemple $L_{B2}$ et $V_D$ des lignes 12 et 22 est positive, et la capacité grille-drain du transistor $T_2$ est alors importante

$L_{B2}$-$V_D = 1,45 - 1,15 = +0,30$ volt

$C_{GD} = 1$ fF$\mu$m, de large

ce qui est important.

Selon l'invention, un circuit translateur de niveaux est associé à chaque circuit amplificateur différentiel de lecture donc à chaque colonne de mémoire.

Ce circuit est constitué d'un premier couple de transistors à effet de champ de type dit MESFET à enrichissement $T_5$ et $T_6$ montés en drain commun à la tension d'alimentation continue $V_{DD}$, et dont les grilles sont commandées respectivement par les signaux portés par les lignes $L_{B1}$ et $L_{B2}$.

Les sources de ces transistors $T_5$ et $T_6$ sont reliées respectivement au drain d'un couple de transistors à effet de champ du type dit MESFET à enrichissement $T_3$ et $T_4$ dont les sources présentent un point commun 20 porté à la masse à travers une charge $R_0$. Les grilles de ces transistors respectivement $T_4$ et $T_3$ sont commandées par les signaux de drain de $T_3$ et $T_4$ et sont reliées respectivement aux grilles 21 et 22 des transistors $T_1$ et $T_2$. Les noeuds 21 et 22 portent respectivement les signaux $V_B$ et $V_A$.

En supposant comme précédemment la tension d'alimentation continue $V_{DD} = 1,5$ volt, les lignes de bit portent les signaux

$L_{B1} = 1,15$ volt

$L_{B2} = 1,45$ volt

Dans ces conditions, les signaux au noeud 21 et 22 sont respectivement

$V_L = 0,57$ volt pour l'état bas

$V_H = 1$ volt pour l'état haut.

Les amplificateurs différentiels sélectionnés par $T_0$ ont une tension grille-drain :

$V_{GD} = -0,15$ volt si $V_A$ est à l'état haut en même temps que $V_D$ est à l'état bas,

et une tension $V'_{GD} = -0,93$ volt si $V_C$ est à l'état haut en même temps que $V_B$ est à l'état bas.

Donc, dans le pire de cas, la tension grille-drain des transistors $T_1$ et $T_2$ de l'amplificateur différentiel de lecture est tout de même négative, et la capacité grille-drain est alors totalement négligeable. Par suite la capacité parasite totale associée au bus de lecture est fortement réduite par rapport à l'état de la technique et la constante de temps qui est le produit de la résistance par ladite capacité est alors très faible.

Les temps d'accès de la mémoire sont réduits. La dispersion du temps d'accès également.

Le tableau I ci-dessous donne les valeurs des retard à mi-croisement obtenues par simulation :

a/ dans le cas où l'amplificateur différentiel de lecture n'est pas muni d'un circuit décaleur de niveau,

b/ dans le cas où l'amplificateur différentiel de lecture est muni d'un circuit décaleur de niveau selon l'invention.

**TABLEAU I**

|  | a | b |
|---|---|---|
| $L_{B1}, L_{B2}$ | 300 ps | 350 ps |
| $V_A, V_B$ | ----- | 450 ps |
| $B_{L1}, B_{L2}$ | 1.05 ns | 850 ps |
| $S_0, S_1$ | 1.3 ns | 1.05 ns |

Dans le tableau I, on appelle :

$L_{B1}$ et $L_{B2}$ les signaux sur les lignes de bit ; l'un de ces signaux est à l'état bas lorsque l'autre est à l'état haut ;

$V_C$ et $V_D$ les signaux sur le bus de lecture ;

$L_{M1}$ et $L_{M2}$ les signaux sur la ligne de MOT de la mémoire, cette partie du circuit mémoire étant connue de l'homme du métier, mais non représentée sur le schéma électrique de la figure 1 : pour réaliser une mémoire compatible avec la présente invention, on pourra se référer par exemple à la publication de P.O'CONNOR et alii, intitulée "High Speed GaAs 1 k bits Static Random Access Memory" dans "IEEE Journal of Solid State Circuits Vol.SC20, N°5, Oct.85, pp.1089-1081" ;

$S_1$ et $S_0$ les signaux en sortie de la mémoire, cette sortie n'étant pas non plus représentée sur le schéma électrique de la figure 1 ;

$V_A$ et $V_D$ les signaux intermédiaires seulement présents dans le circuit selon l'invention.

Le tableau II ci-dessous donne les valeurs du temps de montée du signal de sortie, mesuré entre 20 et 80 % de l'excursion logique, et l'amplitude logique du signal différentiel sur le bus de lecture dans les cas a et b définis précédemment.

**TABLEAU II**

|  | a | b |
|---|---|---|
| temps de montée entre 20-80 % | ≈ 400 ps | 200 ps |
| Signal dif-différentiel sur le bus de lecture | ≈ 200 mV | 350 mV |

On notera que le temps de montée est plus faible dans le cas b car le signal différentiel sur le bus de lecture a une plus grande amplitude.

Ainsi, avec le circuit selon l'invention, le temps d'accès d'une mémoire de 1k bits réalisée sur arséniure de gallium peut être réduit de 250 ps, soit un gain de 20 t. De plus, les temps de transition du signal de sortie sont réduits de 50 %.

Le tableau III ci-dessous donne les dimensions des transistors à effet de champ ainsi que les valeurs des résistances nécessaires à l'élaboration du circuit dans un exemple de réalisation, étant la longueur de grille des transistors et L étant la largeur de grille de ces transistors, qui sont comme on l'a dit du type MESFET. Avantageusement, le circuit sera réalisé monolithiquement intégré avec la mémoire sur un substrat en arséniure de gallium ou un autre composé du groupe III-V.

**TABLEAU III**

| Transistors | $\ell(\mu m)$ | $L(\mu m)$ |
|---|---|---|
| $T_0$ | 0,7 | 10 |
| $T_1, T_2$ | 0,7 | 15 |
| $T_3, T_4$ | 0,7 | 8 |
| $T_5, T_6$ | 0,7 | 9 |
| Résistances | $R (\Omega)$ |  |
| $R_0$ | 600 |  |
| $R_1, R_2$ | 750 |  |

La tension de seuil de ces transistors, qui sont du type dit à enrichissement est:

$V_T = 100$ mV

**Revendications**

1. Mémoire réalisée au moyen de transistors à effet dechamp à enrichissement, sur un substrat semiconducteur du groupe III-V, de préférence en arséniure de gallium (GaAs), comprenant une matrice de mémoire arrangée en rangées et colonnes, chaque cellule de mémoire d'une colonne étant connectée à une première et une seconde ligne de bit (LB1,LB2), lesquelles sont couplées à un amplificateur différentiel de lecture, ce circuit amplificateur différentiel de lecture comprenant deux transistors à effet de champ (T1,T2) couplés par leur source, le point de couplage (10) de ces transistors étant commandé par une source de courant (T0) et cette dernière étant commandée par la sortie ($Y_D$) d'un étage décodeur permettant la sélection de la colonne de mémoire, les grilles de chacun des transistors couplés (T1,T2) recevant le signal d'une ligne de bit (LB1,LB2) de la colonne de la mémoire et les drains (11,12) de ces transistors couplés (T1,T2) fournissant un signal porté sur le bus de lecture de la mémoire caractérisée en ce qu'il lui est adjoint un circuit translateur (T3...T6,R0) des niveaux des signaux transportés par les lignes de bit (LB1,LB2) pour que ces niveaux ($V_B, V_A$) soient au plus égaux aux niveaux des signaux ($V_C, V_D$) portés par le bus de lecture, les entrées du circuit translateur de niveau étant connectées aux lignes de bit et les sorties (21,22) du circuit translateur de niveau étant connectées aux grilles des transistors (T1,T2) couplés par leur source en sorte que les capacités grille-drain des transistors couplés (T1,T2) de l'amplificateur différentiel sont négligeables.

2. Mémoire monolithiquement intégrée selon la revendication 1, caractérisée en ce que le circuit translateur de niveaux est formé d'un premier couple de transistors à effet de champ (T5,T6) montés en drain commun à l'alimentation continue positive $V_{DD}$, dont les grilles reçoivent les signaux des lignes de bit (LB1,LB2) de la colonne de la mémoire, et dont les sources sont chacune raccordées au drain d'un des transistors d'un second couple de transistors à effet de champ (T3,T4) dont les sources sont connectées à la masse à travers une résistance (R0) et dont les grilles sont reliées en croix d'une part au drain du transistor opposé de ce couple (T3,T4) et d'autre part respectivement aux grilles des transistors (T1,T2) de l'amplificateur différentiel de lecture, les lignes du bus de lecture étant reliées à l'alimentation continue $V_{DD}$ à travers des résistances (R1,R2) appariées.

**Claims**

1. A memory constructed by means of enhancement-type field effect transistors provided on a semiconductor substrate of the group III-V, preferably gallium arsenide (GaAs), comprising a memory matrix arranged in rows and columns, each memory cell of a column being connected to a first and a second bit line ($L_{B1}, L_{B2}$) which bit lines are coupled to a differential read amplifier circuit, said differential read amplifier circuit comprising two source-coupled field effect transistors ($T_1, T_2$) the coupling point (10) of which is controlled by a current source ($T_0$) which ifself is controlled by the output signal ($V_D$) of a decoder stage which enables the selection of the memory column, the gates of each of said coupled transistors ($T_1, T_2$) receiving the signal ($L_{B1}, L_{B2}$) of a bit line of the memory column, the drain (11, 12) of the coupled transistors ($T_1, T_2$) of the coupled transistors ($T_1, T_2$) providing a signal to the read bus of the memory, characterized in that a level shift circuit ($T_3,...T_6$) is provided for shifting the levels of the signals transported by the bit lines ($L_{B1}, L_{B2}$) in order to ensure that these levels ($V_A, V_B$) are at the most equal to the levels of the signals ($V_C, V_D$) on the read bus, the inputs of that level shift circuit being connected to the bit lines and the outputs (21,22) of the level shift circuit being connected to the gates of the source-coupled transistors ($T_1, T_2$), so that the gate-drain capacitances of the coupled transistors ($T_1, T_2$) of the differential amplifier are negligible.

2. A monolithic integrated memory as claimed in Claim 1, characterized in that the level shift circuit is formed by a first pair of field effect transistors ($T_5, T_6$) whose common drain is connected to a positive DC supply voltage $V_{DD}$, their gates receiving the signals of the bit lines ($L_{B1}, L_{B2}$) of the memory column, each of their sources being connected to the drain of one of the transistors of a second pair of field effect transistors ($T_3, T_4$) whose sources are connected to ground via a resistance ($R_o$) and whose gates are cross-wise connected on the one hand to the drain of the opposed transistor of the pair ($T_3, T_4$) and on the other hand to the respective gates of the transistors ($T_1, T_2$) of the differential read amplifier, the lines of the read bus being connected to the DC supply voltage $V_{DD}$ via paired resistances ($R_1, R_2$).

**Ansprüche**

1. Speicher, der aus Anreicherungs-Feldeffekttransistoren besteht und auf einem Halbleiterrsubstrat der Gruppe III-V, vorzugsweise aus Galliumarsenid (GaAs), angebracht ist, mit einer in Zeilen und Spalten geordneten Speichermatrix, wobei jedes Speicherelement einer Spalte mit einer ersten und einer zweiten Bitleitung (LB1, LB2) verbunden ist, und diese Bitleitungen an einen Auslese-Differenzverstärker angeschlossen sind, dessen Schaltung zwei Feldeffekttransistoren (T1, T2) enthält, die über ihre Quelle verkoppelt sind, wobei der Koppelpunkt (10) dieser Transistoren durch eine Stromquelle (T0) gesteuert werden und diese Quelle vom Ausgang ($Y_D$) einer Decoderstufe gesteuert wird, wodurch die Wahl der Speicherspalte ermöglicht wird, wobei die Gates jedes der verkoppelten Transistoren (T1, T2) das Signal einer Bitleitung (LB1, LB2) der Speicherspalte empfangen und die Abzüge (11,12) dieser verkoppelten Transistoren (T1, T2) ein am Auslesebus des Speichers zur Verfügung stehendes Signal liefern, dadurch gekennzeichnet, daß darin eine Übersetzerschaltung (T3...T6, $R_0$) zum Übersetzen der über die Bitleitungen (LB1, LB2) zugeleiteten Signalpegel vorgesehen ist, da diese Pegel ($V_B$, $V_A$) höchstens gleich den am Auslesebus liegenden Signalpegeln ($V_C$, $V_D$) sein sollen, wobei die Eingänge der Pegelübersetzerschaltung mit den Bitleitungen und die Ausgänge der Pegelübersetzerschaltung mit den Gates der über ihre Quelle verkoppelten Transistoren (T1, T2) derart verbunden sind, daß die Gate-Abzug-Kapazitäten der mit dem Differenzverstärker gekoppelten Transistoren (T1, T2) vernächlässigbar sind.

2. Monolithisch integrierter Speicher nach Anspruch 1, dadurch gekennzeichnet, daß die Pegelübersetzerschaltung aus einem ersten Paar von Feldeffekttransistoren (T5, T6) mit gemeinsamem Abzug zur positiven Gleichstrommversorgung $V_{DD}$ besteht, deren Gates die Signale der Bitleitungen (LBI, LB2) der Speicherspalte empfangen, und jede der Quellen mit dem Abzug eines der Transistoren eines zweiten Paares von Feldeffekttransistoren (T3, T4) verknüpft sind, deren Quellen über einen Widerstand ($R_0$) an Masse liegen und die Gates kreuzweise einerseits mit dem Abzug des diesem Paar (T3,T4) gegenüberliegenden Transistors und andererseits mit den jeweiligen Gates der Transistoren (T1,T2) des Auslese-Differenzverstärkers verbunden sind, wobei die Auslesebusleitungen über gepaarten Widerständen (R1, R2) an die Gleichstromversorgung $V_{DD}$ angeschlossen sind.

FIG.1

FIG.2